# EUROPÄISCHE PATENTSCHRIFT

(11) **EP 0 413 276 B1**
(45) Veröffentlichungstag und Bekanntmachung des Hinweises auf die Patenterteilung: **10.05.1995**
(21) Anmeldenummer: 90115449.2
(22) Anmeldetag: 11.08.1990
(51) Int. Cl.: H05H 1/24, H05G 2/00

(54) **Vorrichtung zur Erzeugung von Röntgenstrahlung mit einer Plasmaquelle**
Apparatus for producing X-rays by means of a plasma source
Appareil pour produire des rayons X au moyen d'une source de plasma

(30) Priorität: 17.08.1989 DE 3927089
(43) Veröffentlichungstag der Anmeldung: 20.02.1991
(73) Patentinhaber: Firma Carl Zeiss, D-73446 Oberkochen (DE); CARL ZEISS-STIFTUNG HANDELND ALS CARL ZEISS, D-89518 Heidenheim (Brenz) (DE)
(72) Erfinder: Neff, Willi, Dr., B-4721 Helmis (BE); Holz, Raymond, D-5120 Herzogenrath 3 (DE); Lebert, Rainer, D-5100 Aachen (DE); Richter, Franz, D-5190 Stolberg (DE)

(56) Entgegenhaltungen:
- EP-A- 0 140 005
- WO-A-88/08198
- DE-A- 3 332 711
- US-A- 4 627 086
- US-A- 4 841 556

## Beschreibung

Die Erfindung bezieht sich auf eine Vorrichtung zur Erzeugung von Röntgenstrahlung mit einer Plasmaquelle, mit zwei konzentrischen zylindrischen Elektroden, die mit einem steuerbaren Hochleistungsschalter an eine elektrische Hochspannungsenergiequelle anschließbar sind und die zwischen sich einen durch Evakuierung mit Gas geringen Drucks gefüllten Entladungsraum aufweisen, an dessen einem, verschlossenen Ende ein Isolator zwischen den Elektroden angeordnet und eine Zündeinrichtung für eine Plasmaentladung vorhanden ist, deren Plasma zum anderen Ende beschleunigbar und im Bereich des offenen Endes der zylindrischen Innenelektrode zu einem die Röntgenstrahlung emittierenden Plasmafokus komprimierbar ist.

Eine Vorrichtung dieser Art ist aus der DE-OS 33 32 711 bekannt. Diese sogenannte Plasmafokusanlage wird mit einer Gasfüllung oder mit einem bestimmten stationären Gasdurchfluß betrieben. Es wird nur ein einziges Gas verwendet, so daß sowohl die Entladung, als auch die Erzeugung der erwünschten Röntgenstrahlung in ein und demselben Gas erfolgt.

Es hat sich erwiesen, daß die bekannte Vorrichtung eine Reihe von Nachteilen aufweist. Beispielsweise hat die erzeugte Röntgenstrahlung je nach verwendeter Gasart unterschiedliche spektrale Eigenschaften. Es ist also möglich, daß die Ausbeutung an Röntgenstrahlung einer bestimmten, erwünschten Wellenlänge sehr gering ist, oder daß die Erzeugung des Plasmas zu wünschen übrig läßt.

Der Erfindung liegt daher die Aufgabe zugrunde, eine Vorrichtung der eingangs genannten Art so zu verbessern, daß sie optimale Bedingungen für die Zündung der Entladung und für die Beschleunigung des Plasmas zum offenen Ende der zylindrischen Innenelektrode hin hat, zugleich aber auch optimale Bedingungen für die Entstehung der gewünschten Röntgenstrahlung vorliegen.

Diese Aufgabe wird dadurch gelöst, daß das Gas zwischen den Elektroden ein für die Zündung der Plasmaentladung und/oder für die Plasmabeschleunigung optimales Gas (Entladungsgas) ist, daß zumindest im Bereich des offenen Endes der Innenelektrode ein für die zu erzeugende Röntgenstrahlung optimales Gas (Strahlungsgas) vorhanden ist, und daß die beiden Gase (Strahlungsgas und Entladungsgas) einen möglichst durchmischungsarmen Entladungsraum gewährleistend evakuierbar sind.

Gemäß der Erfindung werden unterschiedliche Gase in unterschiedlichen Bereichen der Vorrichtung eingesetzt. Dort sind die Gase für die jeweiligen Abläufe besonders geeignet. Das Entladungsgas ist hinsichtlich eines Parameterbereichs optimiert, der für die Zündung der Plasmaentladung und/oder für die Plasmabeschleunigung von Bedeutung ist, wie Gasdruck, Spannung und elektrische Feldstärke. Beispielsweise sei Helium oder ein anderes Edelgas als Entladungsgas genannt. Für ein solches Entladungsgas kann auch die Beschleunigung des Plasmas, also die Schockwelle, bis zum offenen Elektrodenende optimiert werden, nämlich durch Anpassung der Länge und des Durchmessers der Innenelektrode.

Des weiteren ist für die Erfindung von Bedeutung, daß eine gasmäßige Entkopplung der Phase der Erzeugung der Röntgenstrahlung von der Entladungs/Beschleunigungsphase erreicht wird, nämlich durch das Strahlungsgas. Das Strahlungsgas kann so gewählt werden, daß die entstehende Röntgenstrahlung eine optimale Strahlungsausbeute darstellt, insbesondere in dem gewünschten Wellenlängenbereich. Dieser Wellenlängenbereich beträgt beispielsweise ca. 0,5 bis 5 nm. für die Röntgenmikroskopie bzw. für die Röntgenlithographie. Als Strahlungsgas wird beispielsweise Stickstoff genannt, das für den Bereich von 2,5 nm von Vorteil ist.

Von weiterer Bedeutung ist darüber hinaus, daß die beiden Gase so evakuierbar sind, daß der Entladungsraum möglichst wenig Strahlungsgas beinhaltet, welches für die Zündung der Plasmaentladung und/oder für die Plasmabeschleunigung nicht optimal wäre.

Um in den mit unterschiedlichem Gas zu beschickenden Räumen der Vorrichtung durchmischungsarme Bereiche für die Zündung der Plasmaentladung und/oder für die Plasmabeschleunigung einerseits und für die Erzeugung der Röntgenstrahlung andererseits zu erreichen, ist die Vorrichtung so ausgebildet, daß das entladungsoptimale Gas (Entladungsgas) am geschlossenen Ende des Entladungsraums in diesen und das strahlungsoptimale Gas (Strahlungsgas) in das Innere der Innenelektrode einspeisbar sind, jeweils zum offenen Ende der Innenelektrode hin.

Vorteilhafterweise sind die beiden Gase mit stationären Strömungen eingespeist, die eine im wesentlichen vor und außerhalb des Innenrohrdurchmessers gelegene Durchmischungszone zur Folge haben. Diese Anordnung der Durchmischungszone beeinträchtigt die Hauptfunktionen im Entladungsraum bzw. im Bereich vor dem offenen Innenrohrende nicht, vielmehr können diese ungestört durch das jeweils andere Gas ablaufen.

Es ist stattdessen aber auch möglich, daß das Entladungsgas den Entladungsraum und/oder das Strahlungsgas den Bereich des offenen Innenrohrendes für eine Plasmaentladung mit gepulst eingespeisten Volumen ausfüllt. Während also im ersteren Fall mit stationären Strömungen der Gase gearbeitet wird, ist im zweiten Fall eine Art Impulsfüllung vorhanden, die so erfolgt, daß zum Zeitpunkt einer Plasmaentladung und damit auch während der Phase der Röntgenstrahlungserzeugung Entladungsgas im Entladungsraum und Strahlungsgas im Bereich des offenen Innenrohrendes vorhanden sind. Eine Durchmischung kann also erst erfolgen, nachdem die gewünschte Röntgenstrahlung zuvor erzeugt wurde.

Die Gasabsaugung erfolgt derart, daß der Entladungsraum möglichst nur Entladungsgas enthält, was vorteilhafterweise dadurch erreicht wird, daß die Außenelektrode auf Höhe des offenen Endes der Innenelektrode ringsum verteilte Absaugstellen aufweist. Infolgedessen ist die Konzentration des Strahlungsgases im Entladungsraum zwischen Innen- und Außenelektrode gering. Eine Durchmischungszone stellt sich allenfalls im Bereich der Absaugstellen in der Nähe des offenen Endes der Innenelektrode ein.

Vorteilhafterweise ist die Vorrichtung so ausgebildet, daß die Innenelektrode doppelwandig ist, im Bereich ihres offenen Endes rohrinnenseitig gelegene, ringum verteilte Absaugstellen aufweist und am anderen Ende an eine Absaugeinrichtung angeschlossen ist. Mit einer derartigen Absaugung kann der durch Strahlungsgas vor dem offenen Innenrohrende gelegene Bereich so klein wie möglich gehalten werden.

Die beiden vorbeschriebenen Absaugeinrichtungen stehen für die maximale und die minimale Ausbreitung des strahlungsgasaufweisenden Bereichs. Werden beide kombiniert angewendet, so ergibt sich dadurch einmal eine Einflußnahme auf die Ausdehnung des Strahlungsgas aufweisenden Bereichs und auch die Möglichkeit, unterschiedliche Gaskonzentrationen in diesem Bereich bzw. in den Durchmischungszonen bis hin zum Entladungsraum zu erhalten.

Es hat sich erwiesen, daß das neutrale, nämlich nicht ionisierte Strahlungsgas einen großen Absorptionsquerschnitt für die erzeugte Strahlung hat. Diese wird also zumal in einiger Entfernung vom Plasmafokus bzw. vom Pinchplasma in unerwünschter Weise zur Anregung des Strahlungsgases dienen, steht dann also nicht mehr zur Weiterleitung an eine Arbeitsstelle für die Röntgenmiskroskopie bzw. -Lithographie zur Verfügung. Es ist daher im Sinne der Erfindung sehr förderlich, wenn die Evakuierung bzw. Absaugung des Strahlungsgases sehr wirkungsvoll ist bzw. in einer Weise erfolgt, die die Weiterleitung des größten Anteils der Röntgenstrahlungen zur Bearbeitungsstelle zuläßt. In Weiterbildung der Erfindung wird jedoch dafür gesorgt, daß vor dem Bereich des offenen Endes der Innenelektrode ein damit koaxiales Strahlrohr angeordnet und mit einem für die Übertragung der Röntgenstrahlung optimalen Strahlrohrgas gefüllt ist. Es ist dann zumindest erreicht, daß keinerlei Strahlungsgas in das Strahlrohr gelangt und zumindest der durch dieses Strahlrohr definierte Bereich kann durch die Wahl des Strahlrohrgases für die Übertragung der Röntgenstrahlung optimiert werden.

In Ausgestaltung dieser Vorrichtung ist das Strahlrohrgas in diesem Bereich des offenen Endes des Innenrohrs einströmbar und über die Absaugstelle der Vorrichtung absaugbar. Dabei kann das Einströmen des Strahlrohrgases so gehandhabt werden, daß der Strahlungsgas aufweisende Bereich des offenen Endes des Innenrohrs in seiner axialen Ausdehnung beschränkt wird, so daß die Verluste der Röntgenstrahlung durch Absorption mittels nichtionisierten Strahlungsgases weiter verringert werden.

Die Erfindung wird anhand von in der Zeichnung dargestellten Ausführungsbeispielen erläutert. Es zeigt:
- Fig.1: einen schematischen Querschnitt durch eine erfindungsgemäße Vorrichtung, und
- Fig.2: eine der Fig.1 ähnliche Vorrichtung mit schematisch dargestellten beispielsweisen Absaugeinrichtungen.

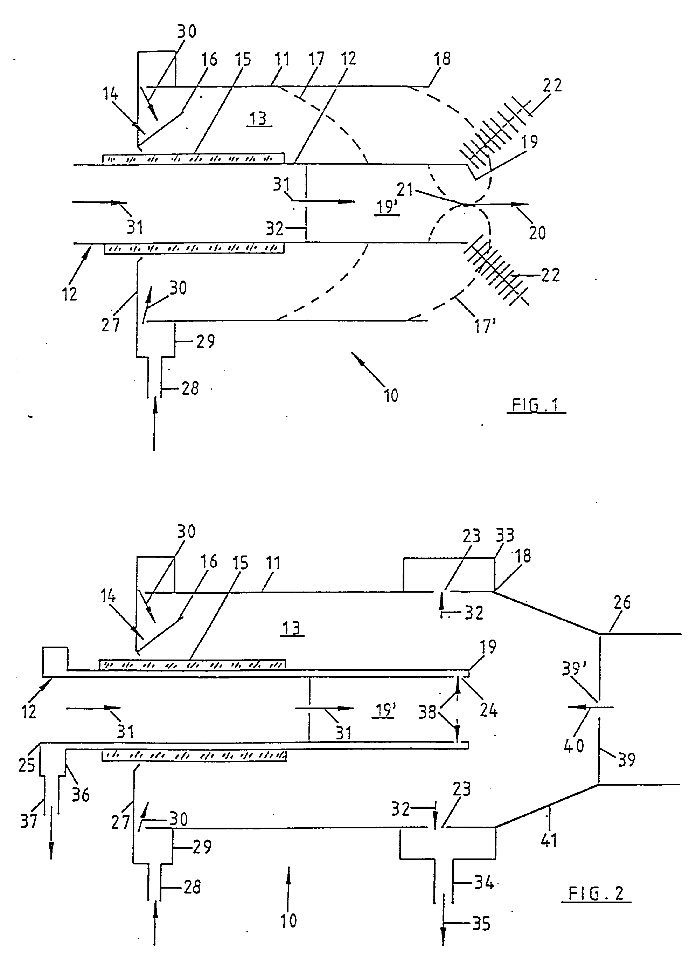

Die in Fig.1 dargestellte Vorrichtung 10 hat zwei konzentrische zylindrische Elektroden 11,12, die mit einem steuerbaren Hochleistungsschalter an eine elektrische Hochspannungsenergiequelle anschließbar sind. Als Beispiel für die Ausbildung eines solchen Hochleistungsschalters und einer solchen Hochspannungsenergiequelle wird auf die deutsche Offenlegungsschrift 33 32 711, insbesondere Fig.1 hingewiesen. Damit ist es möglich, die Innenelektrode 12 gegenüber der beispielsweise auf Erdpotential liegenden Außenelektrode 11 kurzzeitig auf ein mehrere 10 KV betragendes Spannungspotential zu heben. Die sich infolgedessen ergebenden Ionisierungsvorgänge im Entladungsraum zwischen den Elektroden 11,12 werden später beschrieben.

Das in Fig.1 linke Ende 14 des Entladungsraums 13 ist mit einer Wand 27 verschlossen. Die Wand 27 ist ringförmig und zwischen ihr und der Innenelektrode 12 befindet sich ein Isolator 15 in Gestalt eines die Innenelektrode 12 dicht umschließenden Zylinders. Der Isolator 15 schirmt die Wand 27 des Entladungsraums 13 spannungsmäßig gegen die Innenelektrode 12 ab.

Die Wand 27 ist mit der Außenelektrode 11 elektrisch leitend verbunden, hat also deren Potential. Außerdem bildet der Innenumfang der Wand 27 durch eine Abkantung eine Zündeinrichtung 16 für eine Plasmaentladung. Infolge dieser Zündeinrichtung wird sich infolge der Ionisation des im Entladungsraum 13 enthaltenden Gases ein Plasma entwickeln, das sich in Fig.1 wegen der Abschlußwand 14 nach rechts entwickelt und dabei bis zum offenen Ende des Entladungsraums 13 stark beschleunigt wird, so daß eine Plasmaschockwelle entsteht. Das Plasma 17 bzw. die Wellenfront ist in Fig.1 beispielsweise dargestellt. Wenn das Plasma 17 gemäß 17′ in den Bereich des offenen Endes 18 des Entladungsraums 13 und damit in den Bereich des offenen Endes 19 des Innenrohrs 12 gelangt, wird es durch starke magnetische Kräfte zusammengeschnürt. Es entsteht ein Plasmafokus 21 bzw. Pinch, in dem ionisiertes Gas derart komprimiert ist, der neben anderer Strahlung vor allem auch Röntgenstrahlung 20 emittiert. Diese Röntgenstrahlung wird zu einer Bearbeitungsstelle weitergeleitet.

Der Entladungsraum 13 wird mit einem Gas gefüllt, das mittels einer Gaszuleitung 28 und einem Ringkanal 29 gemäß den Pfeilen 30 in das verschlossene Ende 14 des Entladungsraums 13 strömt. Von dieser Einspeisestelle aus strömt es zum offenen Ende 18 der Außenelektrode 11 hin. Das Entladungsgas wird hinsichtlich seiner Zusammensetzung und seines Drucks im Entladungsraum 13 für eine optimale Zündung des Plasmas bzw. für die Plasmabeschleunigung ausgesucht. Vom offenen Ende 18 des Entladungsraums 13 ist das Entladungsgas evakuierbar, so daß im Entladungsraum 13 ein Unterdruck herrscht.

In das Innere 19′ der Innenelektrode 19 wird Strahlungsgas gemäß den Pfeilen 31 eingespeist. Eine Blende 32 dient der Mengenbegrenzung bzw. beschränkt das Eindringen von Entladungsgas, z.B. wenn die Füllung mit Strahlungsgas nur impulsweise erfolgt.

Das Strahlungsgas dringt in einen in Fig.1 im wesentlichen rechts vom offenen Ende 19 des Innenrohrs 12 gelegenen Bereich vor und bildet mit dem Entladungsgas des Entladungsraums 13 Durchmischungszonen 22. Es versteht sich, daß sich die Lage dieser Durchmischungszonen 22 je nach Druck und Strömungsverhältnissen der beiden Gase ändert. In Fig.1 sind die Durchmischungszonen 22 so angeordnet, daß sie im wesentlichen vor und außerhalb des Innenrohrdurchmessers liegen. Infolgedessen ist der Entladungsraum 13 weitgehend strahlungsgasfrei, wie auch der Bereich vor dem offenen Ende 19 des Innenrohrs 12 weitgehend entlandungsgasfrei ist. Das Plasma 17 kann also im Entladungsraum 13 praktisch ohne Behinderung von Strahlungsgas gezündet und beschleunigt werden, und das komprimierte Plasma des Plasmafokus 21 wird praktisch ausschließlich aus Strahlungsgas gebildet, so daß die oben beschriebenen vorteilhaften Verhältnisse bezüglich Erzeugung und Transport des Plasmas einerseits und der Erzeugung der gewünschten Röntgenstrahlung andererseits herrschen.

In Fig.1 wird das Absaugen der beiden Gase und damit das Evakuieren der plasmagefüllten Bereiche offengelassen. Fig.2 zeigt insoweit Konkretisierungen.

Der Absaugung aus dem Entladungsraum 13 dienen an dessen Ende 18 vorhandene Absaugstellen 23, die rings um den Umfang der Außenelektrode 11 verteilt sind. Es strömt also Gas gemäß den Pfeilen 32 durch die Absaugstellen 23 in einen Ringkanal 33 und von dort aus durch einen Absaugstutzen 34 gemäß Pfeil 35 zu einer Absaugeinrichtung, die nicht dargestellt wurde.

Des weiteren ist aus Fig.2 ersichtlich, daß die Innenelektrode 12 doppelwandig ist und an ihrem offenen Ende 19 Absaugstellen 24 hat, die ebenfalls rings um den Innenumfang der Innenelektrode 12 verteilt sind. An anderen Ende der Innenelektrode 12 ist ein Ringkanal 36 mit einem Absaugstutzen 37 vorhanden, der an eine Absaugeinrichtung angeschlossen ist, so daß aus dem Bereich des offenen Innenrohrendes 19 Gas gemäß den Pfeilen 38 abgesaugt wird.

Die Absaugung kann so durchgeführt werden, daß entweder nur durch die Absaugstellen 23 oder nur durch die Absaugstellen 24 abgesaugt wird. Dementsprechend hat das Strahlungsgas eine maximale oder eine minimale Ausbreitung im Bereich des offenen Endes 19 der Innenelektrode 12. Durch eine kombinierte Absaugung sowohl durch die Absaugstellen 23, als auch durch die Absaugstellen 24 kann erreicht werden, daß der Bereich des Strahlungsgases am offenen Ende 19 in seiner Ausdehnung und/oder in seiner Gaszusammensetzung beeinflußt wird. Die sich dadurch ergebenden Strömungs- und Durchmischungszonen werden natürlich auch durch die zuströmenden Mengen bzw. Drücke des Entladungsgases bzw. des Strahlungsgases beeinflußt.

In Fig.2 ist rechts von den Elektroden 11,12 ein Strahlrohr 26 koaxial angeordnet. Dieses dient der Übertragung der erzeugten Röntgenstrahlung zu einer Arbeitsstelle. Es ist mit einem für diese Übertragung optimalen Strahlrohrgas gefüllt und ermöglicht der Röntgenstrahlung den Zutritt durch eine Blendenöffnung 39′ einer das Strahlrohr 26 stirnseitig verschließenden Blende 39.

Das Strahlrohrgas ist für die Übertragung der Röntgenstrahlung optimal, hat also insbesondere einen geringen Absorptionskoeffizienten, so daß die Übertragung weitgehend energieverlustfrei erfolgt. Als Strahlrohrgas kommt beispielsweise Sauerstoff infrage. Es ist wünschenswert, daß derartiges Übertragungsgas bereits möglichst nahe am Plasmafokus 21 vorhanden ist. Das Strahlrohr 26 kann jedoch nicht beliebig an das offene Ende 19 der Innenelektrode 12 herangebracht werden, weil beispielsweise Platz für die Schockwelle des Plasmas 17 benötigt wird. Es ist daher vorteilhaft, das Strahlrohrgas gemäß dem Pfeil 40 durch die Blendenöffnung 39′ in den Bereich des offenen Endes 19 des Innenrohrs 12 einströmbar ist. Dieses Strahlrohrgas kann mit den anderen beiden Gasen abgesaugt werden. Wenn beispielsweise zwischen der Außenelektrode 11 und dem Strahlrohr 26 eine abdichtende konusförmige Isolierung 41 vorhanden ist, erfolgt das Absaugen über die Absaugstellen 32 und/oder 24.

## Patentansprüche

1. Vorrichtung (10) zum Erzeugen von Röntgenstrahlung (20) mit einer Plasmaquelle, mit zwei konzentrischen zylindrischen Elektroden (11,12), die mit einem steuerbaren Hochleistungsschalter an eine elektrische Hochspannungsenergiequelle anschließbar sind und die zwischen sich einen durch Evakuierung mit Gas geringen Drucks gefüllten Entladungsraum (13) aufweisen, an dessen eine, verschlossenen Ende (14) ein Isolator (15) zwischen den Elektroden (11,12) angeordnet und eine Zündeinrichtung (16) für eine Plasmaentladung vorhanden ist, deren Plasma (17) zum anderen Ende (18) beschleunigbar und im Bereich des offenen Endes (19) der zylindrischen Innenelektrode (12) zu einem die Röntgenstrahlung (20) emittierenden Plasmafokus (21) komprimierbar ist, **dadurch gekennzeichnet,** daß das Gas zwischen den Elektroden (11,12) ein für die Zündung der Plasmaentladung und/oder für die Plasmabeschleunigung optimales Gas (Entladungsgas) ist, daß zumindest im Bereich des offenen Endes (19) der Innenelektrode (12) ein für die zu erzeugende Röntgenstrahlung (20) optimales Gas (Strahlungsgas) vorhanden ist, und daß die beiden Gase (Strahlungsgas und Entladungsgas) einen möglichst durchmischungsarmen Entladungsraum (13) gewährleistend evakuierbar sind.

2. Vorrichtung nach Anspruch 1, **dadurch gekennzeichnet,** daß das entladungsoptimale Gas (Entladungsgas) am geschlossenen Ende des Entladungsraums in diesen und das strahlungsoptimale Gas (Strahlungsgas) in das Innere (19′) der Innenelektrode (12) einspeisbar sind, jeweils zum offenen Ende (19) der Innenelektrode (12) hin.

3. Vorrichtung nach Anspruch 2, **dadurch gekennzeichnet,** daß die beiden Gase mit stationären Strömungen eingespeist sind, die eine im wesentlichen vor und außerhalb des Innenrohrdurchmessers gelegene Durchmischungszone (22) zur Folge haben.

4. Vorrichtung nach Anspruch 2, **dadurch gekennzeichnet,** daß das Entladungsgas den Entladungsraum (13) und/oder das Strahlungsgas den Bereich des offenen Innenrohrendes (19) für eine Plasmaentladung mit gepulst eingespeisten Volumen ausfüllt.

5. Vorrichtung nach einem oder mehreren der Ansprüche 1 bis 4, **dadurch gekennzeichnet,** daß die Außenelektrode (11) auf Höhe des offenen Endes (19) der Innenelektrode (12) ringsum verteilte Absaugstellen (23) aufweist.

6. Vorrichtung nach einem oder mehreren der Ansprüche 1 bis 5, **dadurch gekennzeichnet,** daß die Innenelektrode (12) doppelwandig ist, im Bereich ihres offenen Endes (19) rohrinnenseitig gelegene, ringum verteilte Absaugstellen (24) aufweist und am anderen Ende (25) an eine Absaugeinrichtung angeschlossen ist.

7. Vorrichtung nach einem oder mehreren der Ansprüche 1 bis 6, **dadurch gekennzeichnet,** daß vor dem Bereich des offenen Endes (19) der Innenelektrode (12) ein damit koaxiales Strahlrohr (26) angeordnet und mit einem für die Übertragung der Röntgenstrahlung (20) optimalen Strahlrohrgas gefüllt ist.

8. Vorrichtung nach Anspruch 7, **dadurch gekennzeichnet,** daß das Strahlrohrgas in den Bereich des offenen Endes (19) des Innenrohrs (12) einströmbar und über die Absaugstellen (23,24) der Vorrichtung (10) absaugbar ist.

## Claims

1. A device (10) for generating X-radiation (20) with a plasma source, with two concentric cylindrical electrodes (11, 12), which can be connected to a high-voltage electrical energy source via a controlled high-power switch and which exhibit between them a discharge space (13) filled with low pressure gas by means of evacuation, at one closed end (14) of which discharge space an insulator (15) is arranged between said electrodes (11, 12) and there is an initiating means (16) for a plasma discharge, whose plasma (17) can be accelerated to the other end (18) and, in the region of the open end (19) of the cylindrical inner electrode (12), can be compressed into a plasma focus (21) emitting X-radiation (21), characterised by the fact that the gas between the electrodes (11, 12) is a gas (discharge gas) optimal for initiation of the plasma discharge and/or for the plasma acceleration, that a gas (emitting gas) optimal for the X-radiation (20) to be generated is present at least in the region of the open end (19) of the inner electrode (12), and that the two gases (emitting gas and discharge gas) can be evacuated so as to assure a discharge space (13) with the least possible intermixing.

2. A device in accordance with claim 1, characterized by the fact that the discharge-optimal gas (discharge gas) is injectable into the discharge space at the closed end of said discharge space and the emission-optimal gas (emitting gas) is injectable into the interior (19') of the inner electrode (12), in each case toward the open end (19) of the inner electrode (12).

3. A device in accordance with claim 2, characterized by the fact that the two gases are injected with steady flows, which have as a consequence an intermixing zone (22) located substantially in front of and outside the diameter of the inner tube.

4. A device in accordance with claim 2, characterized by the fact that the discharge gas fills the discharge space (13) and/or the emitting gas fills the region of the open end (19) of the inner tube for a plasma discharge with pulsewisely injected volumes.

5. A device in accordance with one or a plurality of claims 1-4, characterized by the fact that the outer electrode (11) exhibits extraction points (23) distributed around the circumference at the level of the open end (19) of the inner electrode (12).

6. A device in accordance with one or a plurality of claims 1-5, characterized by the fact that the inner electrode (12) is double-walled, exhibits extraction points (24) distributed around the circumference on the inner side of the tube in the region of its open end (19), and is connected to an extraction means at the other end (25).

7. A device in accordance with one or a plurality of claims 1-6, characterized by the fact that a beam tube (26) is arranged in front of the region of the open end (19) of the inner electrode (12) and coaxial therewith and is filled with a beam-tube gas optimal for the transmission of the X-radiation (20).

8. A device in accordance with claim 7, characterized by the fact that the beam-tube gas in the region of the open end (19) of the inner tube (12) can be allowed to flow in and can be extracted via the extraction points (23, 24) of the device (10).

## Revendications

1. Dispositif (10) pour la production de rayons X (20) avec une source plasma, composé de deux électrodes cylindriques et concentriques (11, 12) ). Les deux électrodes sont raccordables à une source d'énergie électrique haute tension par l'intermédiaire d'un commutateur haute tension régulable et forment entre elles un espace de décharge (13) rempli, par évacuation, d'un gaz faiblement comprimé; du côté fermé de cet espace (14) se trouvent un isolateur (15) placé entre les électrodes (11, 12) et le dispositif d'allumage (16) pour la décharge plasma; le plasma (17) est accéléré vers l'autre extrémité (18) et concentré, au niveau de l'extrémité ouverte (19) de l'électrode intérieure cylindrique (12) sur un foyer plasma (21) émettant des rayons X (20); le tout caractérisé par le fait que le gaz entre les électrodes (11, 12) est un gaz optimal pour l'excitation et/ou l'accélération du plasma (appelé gaz de décharge), qu'un gaz optimal pour la production de rayons X (20) (appelé gaz de rayonnement) est présent au moins au niveau du côté (19) de l'électrode intérieure (12) et que les deux gaz (gaz de décharge et gaz de rayonnement) sont évacuables en évitant le plus possible de se mélanger dans l'espace de décharge (13).

2. Dispositif conforme à la revendication 1, caractérisé par le fait que le gaz de décharge (favorisant optimalement la décharge) est injectable dans l'espace de décharge depuis son côté fermé et que le gaz de rayonnement (favorisant optimalement le rayonnement) est injectable à l'intérieur (19) de l'électrode intérieure (12), respectivement en direction du côté ouvert (19) de l'électrode intérieure (12).

3. Dispositif conforme à la revendication 2, caractérisé par le fait que les deux gaz sont injectés avec des flux stationnaires, avec pour conséquence la formation une zone de mélange (22) située principalement devant et en dehors du diamètre du cylindre intérieur.

4. Dispositif conforme à la revendication 2, caractérisé par le fait que le gaz de décharge emplit l'espace de décharge (13) et/ou que le gaz de rayonnement emplit la zone du cylindre intérieur (19) située côté ouvert, pour une décharge plasma avec des volumes injectés de façon pulsée.

5. Dispositif conforme à l'une des revendications 1 à 4, caractérisé par le fait que l'électrode externe (11) présente au niveau de l'extrémité ouverte (19) de l'électrode intérieure (12) des points d'évacuation disposés de façon circulaire (23).

6. Dispositif conforme à l'une des revendications 1 à 5, caractérisé par le fait que l'électrode intérieure (12) est à double paroi, qu'elle présente au niveau de son extrémité ouverte (19) et sur sa face intérieure des points d'évacuation disposés de façon circulaire (24) et qu'elle est raccordée à son autre extrémité (25) à une unité d'évacuation.

7. Dispositif conforme à l'une des revendications 1 à 6, caractérisé par le fait que devant l'extrémité ouverte (19) de l'électrode intérieure (12) se trouve un tube d'émission coaxial (26) et qu'il est rempli d'un gaz favorisant de façon optimale la transmission des rayons X (20).

8. Dispositif conforme à la revendication 7 caractérisé par le fait que le gaz pour le tube d'émission est injectable au niveau de l'extrémité ouverte (19) de l'électrode intérieure (12) et refoulable par les points d'évacuation (23, 24) du dispositif (10).
